# EUROPEAN PATENT APPLICATION

(11) **EP 1 542 523 A1**
(43) Date of publication of application: **15.06.2005**
(21) Application number: 03766669.0
(22) Date of filing: 31.07.2003
(51) Int. Cl.: H05K 13/04

(54) **PART MOUNTING RECOGNITION MARK RECOGNITION DEVICE AND METHOD**

(30) Priority: 01.08.2002 JP 2002224836
(71) Applicant: MATSUSHITA ELECTRIC INDUSTRIAL CO., LTD., Kadoma-shi, Osaka 571-8501 (JP)
(72) Inventor: KABESHITA, Akira, Hirakata-shi, Osaka 573-0115 (JP); HACHIYA, Eiichi, Chikushino-shi, Fukuoka 818-0059 (JP)
(74) Representative: Eisenführ, Speiser & Partner
(86) International application number: PCT/JP2003/009708
(87) International publication number: WO 2004/014117

(57) **Abstract**

In a component placement recognition mark recognizing device for recognizing recognition marks (71) for component placement that are provided corresponding to component placement positions (70) where components are to be placed in a plurality of partition areas (2A) on a board (2), the device has a recognition camera (90) for recognizing the recognition marks straightly disposed in the plurality of areas and a moving device (5, 15) for running the recognition camera at a generally uniform velocity in a deposition direction in which the recognition marks are straightly disposed, and the recognition marks are recognized with use of the recognition camera while the recognition camera is run by the moving device.

## Description

### Technical Field

The present invention relates to a recognizing device and a recognizing method for recognizing recognition marks that are provided corresponding to a plurality of component placement positions on a board for recognition of the component placement positions.

### Background Art

For a so-called multi-product board that is partitioned into a number of regions on each of which components are to be placed, conventionally, a recognition camera is moved to and stopped at a recognition mark provided in vicinity of a component placement position, for recognition of the component placement position in each of the regions, and then the recognition mark is recognized. The recognition camera is subsequently moved to and stopped at a next recognition mark, termination of vibrations owing to an inertial force upon the stoppage of the camera is awaited, the mark is thereafter recognized with the recognition camera, and thus all the recognition marks are recognized. Then components are placed on the component placement positions on basis of positions of the recognized recognition marks.

The above structure, however, has an issue in that long time for the recognition prevents reduction in mounting takt (cycle time) because all the recognition marks are recognized one by one with stoppage of the recognition camera.

Therefore, an object of the present invention is to resolve the issue and to provide a recognizing device and a recognizing method by which recognition time can be reduced greatly.

### Disclosure Of Invention

In order to achieve the object, the present invention is configured as follows.

In accordance with a first aspect of the present invention, there is provided a component placement recognition mark recognizing device for recognizing recognition marks for component placement that are provided corresponding to component placement positions where components are to be placed in a plurality of partition areas on a board, the component placement recognition mark recognizing device comprising:
a recognition camera for recognizing the recognition marks straightly disposed in the plurality of areas, and
a moving device for running the recognition camera at a generally uniform velocity in a deposition direction in which the recognition marks are straightly disposed,
wherein the recognition marks are recognized with use of the recognition camera while the recognition camera is run by the moving device.

According to a second aspect of the present invention, there is provided a component placement recognition mark recognizing device as defined in the first aspect, wherein the velocity at which the recognition camera is run by the moving device is a velocity obtained from a distance between adjoining recognition marks divided by time required for capture of an image of the recognition mark.

According to a third aspect of the present invention, there is provided a component placement recognition mark recognizing device as defined in the first or second aspect, wherein the plurality of areas are made into one block and wherein the recognition marks for component placement that are located in a confronting pair of corners of the block and in different areas are recognized with use of the recognition camera.

According to a fourth aspect of the present invention, there is provided a component placement recognition mark recognizing method for recognizing recognition marks for component placement that are provided corresponding to component placement positions where components are to be placed in a plurality of partition areas on a board,
the component placement recognition mark recognizing method comprising: respectively recognizing the recognition marks straightly disposed in the plurality of areas with use of a recognition camera while the recognition camera is run at a generally uniform velocity in a deposition direction in which the recognition marks are straightly disposed.

According to a fifth aspect of the present invention, there is provided a component placement recognition mark recognizing method as defined in the fourth aspect, wherein the velocity at which the recognition camera is run by the moving device is a velocity obtained from a distance between adjoining recognition marks divided by time required for capture of an image of the recognition mark.

According to a sixth aspect of the present invention, there is provided a component placement recognition mark recognizing method as defined in the fourth or fifth aspect, wherein the recognition marks for component placement that are located in a confronting pair of corners of one block composed of the plurality of areas and positioned in different areas are recognized with use of the recognition camera.

### Brief Description Of Drawings

Fig. 1 is a perspective view of a component mounting apparatus in accordance with a first embodiment of the present invention;
Fig. 2 is a plan view of the component mounting apparatus in accordance with the first embodiment of the present invention;
Fig. 3 is a plan view of a board that is to be recognized by the component mounting apparatus in accordance with the first embodiment of the present invention;
Figs. 4A and 4B are a partially enlarged plan view of the board that is to be recognized by the component mounting apparatus in accordance with the first embodiment of the present invention and a graph of running velocity of a recognition camera of the component mounting apparatus;
Fig. 5 is a partially enlarged plan view of a state in which a component has been placed in an area on the board that is to be recognized by the component mounting apparatus in accordance with the first embodiment of the present invention;
Fig. 6 is a partially enlarged plan view of a board that is to be recognized by a component mounting apparatus in accordance with another embodiment of the present invention;
Fig. 7 is a partially enlarged plan view of a board that is to be recognized by a component mounting apparatus in accordance with still another embodiment of the present invention; and
Fig. 8 is a block diagram of the component mounting apparatus of Fig. 1.

### Best Mode for Carrying Out the Invention

Before the description of the present invention proceeds, it is to be noted that like parts are designated by like reference numerals throughout the accompanying drawings.

Hereinbelow, embodiments of the present invention will be described in detail with reference to the drawings.

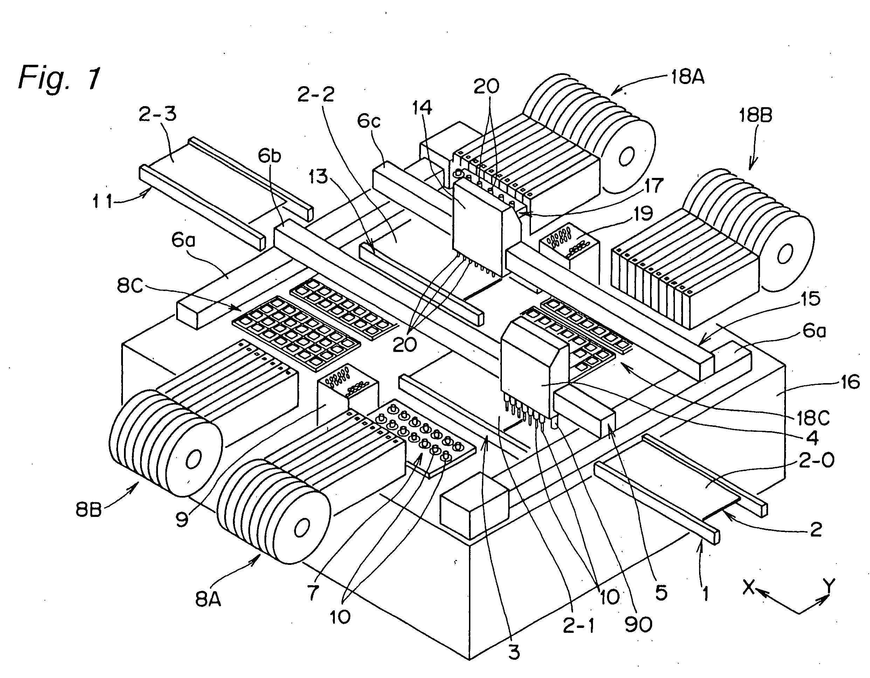

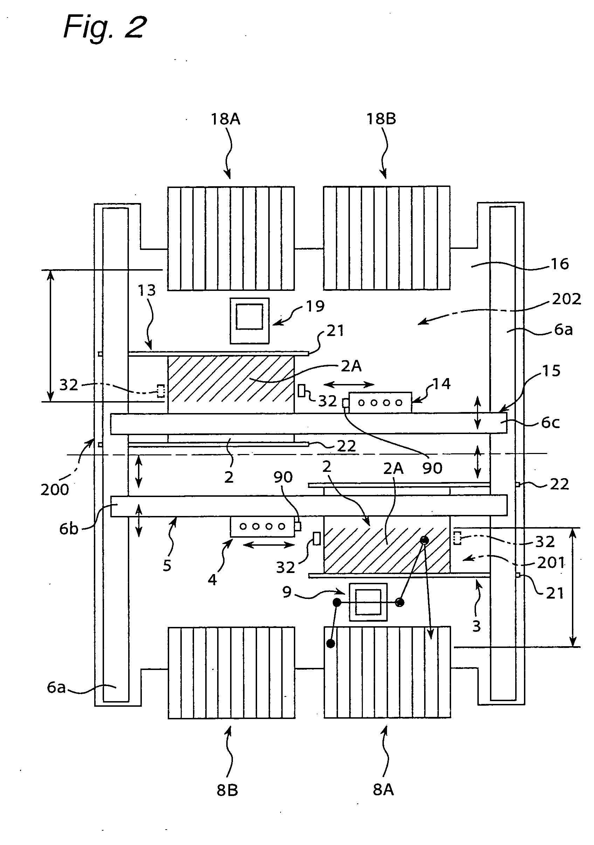

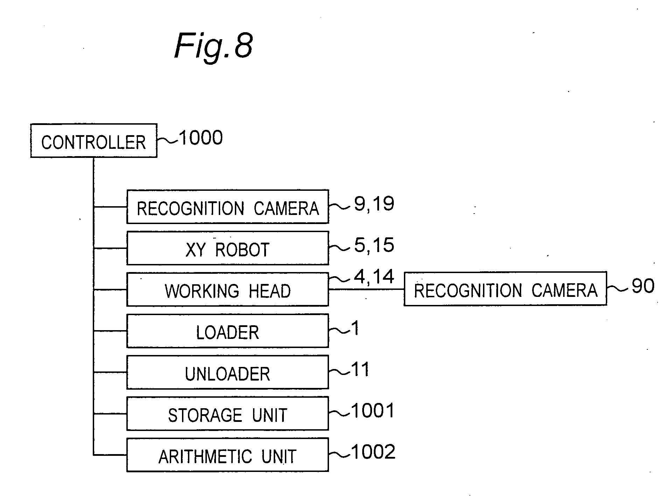

In Figs. 1 and 2 is shown a component mounting apparatus having a device for recognizing recognition marks for component placement that is capable of performing a method for recognizing recognition marks for component placement in accordance with a first embodiment of the present invention. As shown in Figs. 1 and 2, the component mounting apparatus has: board conveying and holding devices 3 and 13 for holding boards 2 in board holding positions; component feeding cassettes 8A, 8B, 18A, and 18B as an example of component feeding units for accommodating components 80 that are to be placed on the boards 2; placing heads 4 and 14 having nozzles 10, as an example of component holding members capable of holding the components 80, and having recognition cameras 90 such as CCD camera capable of recognizing marks 69, 71, and 72 on the boards; component recognizing devices 9 and 19 such as CCD camera for recognizing postures of the components 80 sucked and held by the nozzles 10; moving devices 5 and 15 composed of XY robots for moving the placing heads 4 and 14 between the component feeding cassettes 8A, 8B, 18A, 18B, the component recognizing devices 9, 19, and the board conveying and holding devices 3, 13; and a controller 1000 (see Fig. 8) for controlling operations of the devices and the members.

The XY robots 5 and 15 are configured as follows. Two Y-axis drive units 6a, 6a of an XY robot device 6 are fixed to a front end and a back end, with respect to a board conveying direction, of a component mounting area 200 on a mounting apparatus base 16, two X-axis drive units 6b, 6c laid on and across the two Y-axis drive units 6a, 6a are provided so as to be capable of moving independently in Y-axis directions and capable of avoiding collision, the working head 4 that moves in a first mounting area 201 is provided on the X-axis drive unit 6b so as to be capable of moving in X-axis direction, and the working head 14 that moves in a second mounting area 202 is provided on the X-axis drive unit 6c so as to be capable of moving in the X-axis direction. The XY robot 5 is thus composed of the two Y-axis drive units 6a, 6a fixed to the mounting apparatus base 16, the X-axis drive unit 6b capable of moving in the Y-axis direction on the Y-axis drive units 6a, 6a, and the working head 4 capable of moving in the X-axis direction on the X-axis drive unit 6b. The XY robot 15 is composed of the two Y-axis drive units 6a, 6a fixed to the mounting apparatus base 16, the X-axis drive unit 6c capable of moving in the Y-axis direction on the Y-axis drive units 6a, 6a, and the working head 14 capable of moving in the X-axis direction on the X-axis drive unit 6c.

In the component mounting apparatus, as shown in Fig. 2, a first component mounting unit on lower left side in Fig. 1 is composed of the board conveying and holding device 3, the component feeding cassettes 8A, 8B, the placing head 4, the moving device 5, and the component recognizing device 9. A second component mounting unit on upper right side in Fig. 1 is composed of the board conveying and holding device 13, the component feeding cassettes 18A, 18B, the placing head 14, the moving device 15, and the component recognizing device 19. The two component mounting units are capable of functioning independently of each other as component mounting apparatus, and therefore one of the component mounting units will be described below.

In the one component mounting apparatus, as shown in Figs. 1 and 2, a board carrying-in path at center from board carrying-in side to board carry-out side divides the component mounting area 200 for boards 2 into the first mounting area 201 and the second mounting area 202. In the first mounting area 201, a board 2-1 is carried by a loader 1 onto the board conveying and holding device 3 positioned in a center position in the first mounting area 201, the board conveying and holding device 3 is moved from the center position to a part nearest to the component feeding unit 8A provided in an end portion of the first mounting area 201 along a direction of the board carrying-in path and nearest to the recognition camera 9 as an example of a first component recognizing unit, and thus the board 2-1 is held in position for a mounting operation. Then, in the first mounting area 201, components are then sucked from the component feeding units 8A, 8B, held, and mounted on at least half an area (a diagonally shaded area 2A of Fig. 2) of the board 2-1 on near side as seen looking from an operator near to the first component feeding unit 8A. After completion of the mounting operation in the first mounting area 201, the board conveying and holding device 3 is returned to the center position, and the board 2-1 is thereafter transferred from the board conveying and holding device 3 onto the board conveying and holding device 13 positioned in the center position and adjacent to the board conveying and holding device 3. Subsequently, the board conveying and holding device 13 is moved from the center position so that the board 2-1 is moved to a part of the second mounting area 202 nearest to the component feeding unit 18A and nearest to the recognition camera 19 as an example of a second component recognizing unit, and the board 2-1 is held in position for a mounting operation. In the second mounting area 202, subsequently, components are sucked from the component feeding units 18A, 18B, held, and mounted on at least half an area (a diagonally shaded area 2A of Fig. 2) of the board 2-1 on far side as seen looking from an operator near to the component feeding unit 18A. Then, after completion of the mounting operation in the second mounting area 202, the board conveying and holding device 13 is returned to the center position, and the board 2-1 is thereafter transferred from the board conveying and holding device 13 onto an unloader 11, and is carried out of the second mounting area 202. As a result, shortest distances between a board 2 held in position in the mounting areas 201, 202, the component feeding units 8A, 18A, and the recognizing cameras 9, 19 can greatly be reduced in comparison with a conventional apparatus in which boards are held on a board carrying-in path in a component mounting area, and thus reduction in mounting time and improvement in productivity can be achieved.

The board 2 is partitioned into a plurality of areas 2A, and a recognition mark 71 for component placement is provided corresponding to a component placement position 70 in which a component 80 is to be placed in each area 2A. Typically, the recognition marks 71 for component placement are provided in diagonal positions in vicinity of the component placement positions 70 for the respective components 80.

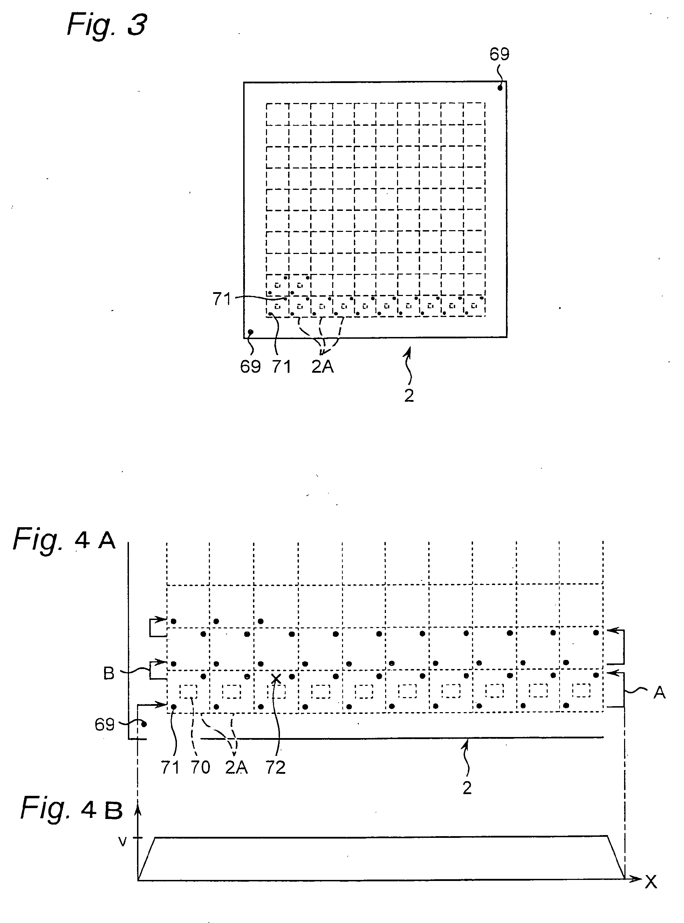

In an example, as shown in Figs. 3 and 4, the component placing areas 2A with overall dimensions of 100 mm by 100 mm on the board 2 are partitioned in a grid pattern into one hundred square-like areas 2A each measuring 10 mm by 10 mm. In each area 2A, the marks 71 for component position recognition are provided in diagonal positions with the component placement position 70 between. Among manners of disposition of marks 71 for component position recognition are a manner in which marks 71 for component position recognition are respectively disposed in diagonal positions for one component placement position 70, a manner in which marks 71A for component position recognition are respectively disposed in outermost diagonal positions in a component placing area 2A including a plurality of component placement positions, and the like.

In the component mounting operation, initially, the moving device 5 drives the placing head 4 to move, and a pair of board recognition marks 69 for board positioning provided in diagonal positions as shown in Fig. 3 on the oblong or square board 2 held by the board conveying and holding device 3 are individually recognized with use of the recognition camera 90 on the placing head 4. Thus the pair of board recognition marks 69 for board positioning on the board 2 held by the board conveying and holding device 3 or 13 are recognized, and positioning of the board 2 on basis of a point of origin of the component mounting apparatus is performed with movement of the board 2 in the X direction or the Y direction with drive of the board conveying and holding device 3 on basis of a result of the recognition of the pair of board recognition marks 69 for board positioning.

Subsequently, a pair of recognition marks 71 for component placement position are recognized that correspond to a component placement position 70 in each area 2A on the positioned board 2 which has been partitioned into a number of areas 2A in advance. As shown in Fig. 3, the recognition marks 71 for component placement position are disposed in vicinity of a pair of diagonal corners in each area 2A so that the component placement position 70 in each area 2A is interposed between the marks 71, and the recognition marks 71 are disposed in one straight line in a lateral direction on the board 2, i.e., in the X direction, and in one straight line in a longitudinal direction on the board 2, i.e., in the Y direction. Accordingly, for example, the moving device 5 drives the placing head 4 to move straightly in the X direction (a rightward direction in Figs. 3 and 4) from a recognition mark 71 for component placement position in a lower left corner of a lowest and leftmost area 2A on the board 2. In this operation, the placing head 4 is continuously run at a uniform velocity v which allows recognition processing, instead of being stopped at every position corresponding to the recognition marks 71, the recognition marks 71 are recognized in succession, and results of the recognition are stored into a storage unit 1001 (see Fig. 8) in the controller 1000.

Subsequently, a recognition mark 71 for component placement position in a lower left corner of a lowest and rightmost area 2A on the board 2 is recognized, the camera thereafter goes out of the area 2A and moves in the Y direction by a distance that makes it possible to recognize a recognition mark 71 for component placement position in an upper right corner of the area 2A. Then the moving device 5 drives the placing head 4 to move straightly in an X direction (a leftward direction in Figs. 3 and 4) opposite to the above so that recognition is started from the recognition mark 71 for component placement position in the upper right corner of the area 2A, the placing head 4 continues to run at the uniform velocity v which allows recognition processing, and recognition marks 71 are recognized in succession (see an arrow A).

Subsequently, a recognition mark 71 for component placement position in an upper right corner of the lowest and leftmost area 2A on the board 2 is recognized, the camera thereafter goes out of the area 2A and moves in the Y direction by a distance that makes it possible to recognize a recognition mark 71 for component placement position in a lower left corner of an area 2A on top of the area 2A. Then the moving device 5 drives the placing head 4 to move straightly in the X direction (the rightward direction in Figs. 3 and 4) so that recognition is started from the recognition mark 71 for component placement position in the lower left corner of the area 2A, the placing head 4 continues to run at the uniform velocity v which allows recognition processing, and recognition marks 71 are recognized in succession (see an arrow B) .

In this manner, the recognition marks 71 for component placement position in the lower left corners and the recognition marks 71 for component placement position in the upper right corners in the areas 2A are continuously recognized without the stoppage one by one.

Placing steps are subsequently performed after completion of the recognition of all the recognition marks 71 for component placement position in both the lower left corners and the upper right corners of the areas 2A. That is, positional deviations in the component placement positions 70 in the areas 2A are calculated in an arithmetic unit 1002 (see Fig. 8) of the controller 1000, on basis of results of the recognition of the recognition marks 71 for component placement position in both the lower left and upper right corners of the areas 2A.

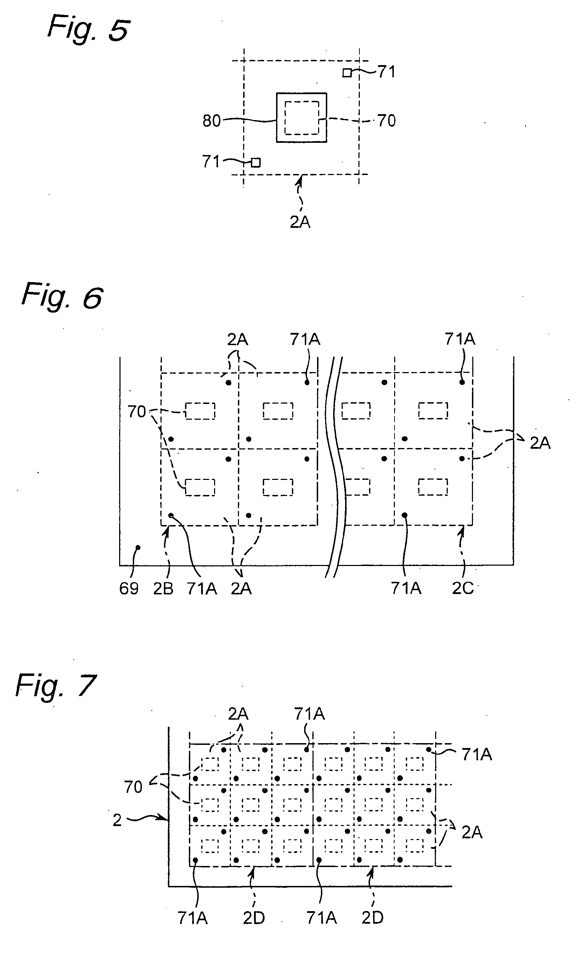

On the other hand, components 80 fed from the component feeding cassette 8A are sucked and held by the nozzles 4, and postures of the components 80 are thereafter recognized with use of the component recognition camera 9. The postures of the components 80 are corrected on basis of the results of the recognition, and the components 80 are thereafter placed on the component placement positions 70 in the areas 2A, as shown in Fig. 5, in consideration of the positional deviations that have previously been calculated.

In locations where components are not required to be placed because of such a factor as poorly printed solder etc. are put bad marks (faulty location indication marks) 72, as shown by "X" mark in Fig. 4, which are required to be recognized. Provided that the bad marks 72 are positioned on paths on which the placing head 4 travels in the X direction for the recognition of the recognition marks 71, the bad marks 72 can be detected simultaneously with the recognition of the recognition marks 71.

On basis of specific examples, hereinbelow, the recognizing operations in accordance with the embodiment will be compared with conventional operations.

In a conventional example, a recognition camera is moved at a velocity of 10 mm with respect to 56 ms, for example, relative to recognition marks and is stopped temporarily in a position corresponding to a recognition mark. After termination of vibrations owing to an inertial force upon the stoppage of the camera (stabilization of a mechanism) is awaited for 75 to 100 ms, the recognition mark is recognized for 50 ms with use of the recognition camera. Subsequently, the recognition camera is moved afresh to the next recognition mark at the velocity of 10 mm with respect to 56 ms and is stopped temporarily in a position corresponding to the recognition mark, and a recognizing operation is performed. Such a series of operations are performed for all the recognition marks, and all the recognition marks are thereby recognized. In the conventional example, therefore, 56 ms + (75 to 100 ms) + 50 ms = 181 to 206 ms is required for each of one-hundred recognition marks, for example, and thus (181 to 206 ms) × 100 = 18100 to 20600 ms = 18.1 to 20.6 s is required as a whole. In addition, 15 s may be required for the recognition of the bad marks, and thus (18.1 to 20.6 s) + 15 s = 33.1 to 35.6 s may be required in total.

In the above embodiment, by contrast, time for capture of an image of a recognition mark 71 into the storage unit 1001 of 16 ms and a distance between positions of the recognition marks of 10 mm, for example, provide a quotient of 10 mm/16 ms ≈ 625 mm/s. On condition that the moving device 5 drives the placing head 4 to run at a velocity not larger than 625 mm/s, accordingly, the recognition marks 71 can be recognized while the head 4 is being run. In the embodiment, therefore, 100 mm/(625 mm/s) = 0.16 s is required for each lateral row in one-hundred recognition marks (in each row, a total of ten recognition marks exist at intervals of 10 mm and a maximum distance between the recognition marks is 100 mm), and thus 0.16 s × 10 (rows) = 1.6 s is required as a whole. In addition, 0.5 s is required for the recognition of the bad marks in each row, 2.5 s is required for the longitudinal movement, 0.5 s × 10 (rows) = 5 s is required as a whole, and thus 1.6 s + 0.5 s + 2.5 s = 4.6 s is required in total. Thus the required time can be reduced to about one-eighth in general of that in the conventional example.

In accordance with the embodiment, operations of recognizing the recognition marks 71 are executed while the placing head is run at the generally uniform velocity v without being stopped one by one at every recognition mark 71 for the recognition. Thus the recognition time can be reduced greatly, and mounting takt (cycle time) can be reduced.

The invention is not limited to the above embodiment but may be embodied in other various manners.

For example, the embodiment is intended for the square boards 2, and the recognition camera 90 is run in lateral directions; however, a configuration is possible in which the recognition camera is run in longitudinal directions.

In the embodiment, all the recognition marks 71 in the areas 2A are recognized. This is necessary on condition that an accuracy in component placement is high (e.g., of ±10 µm). On condition that an accuracy in component placement is not so high (e.g., on the order of ±50 to 100 µm), on the other hand, recognition of recognition marks 71 may be performed for every group consisting of a plurality of areas 2A, instead of the recognition of all the recognition marks 71 in the areas 2A. In recognition of recognition marks 71 in the areas 2A, specifically, a pair of recognition marks 71 in diagonal corners in each block composed of a plurality of areas 2A may be recognized, instead of the method in which a pair of recognition marks 71 are recognized for each area 2A. Provided that four adjoining areas 2A are treated as one block 2B as shown in Fig. 6, for example, a recognition mark 71A in a lower left corner of a lower left area 2A in the block 2B and a recognition mark 71A in an upper right corner of an upper right area 2A in the block 2B have only to be recognized. Instead of the method in which four adjoining areas 2A are treated as one block 2B, two adjoining areas 2A may be treated as one block 2C or nine adjoining areas 2A may be treated as one block 2D as shown in Fig. 7. That is, an arbitrary number (two or more) of adjoining areas 2A may be treated as one block. For each block, a recognition mark 71A in a lower left corner of the block and a recognition mark 71A in an upper right corner of the block have only to be recognized.

Such methods can accelerate mounting takt (cycle time) on condition that an accuracy in component placement is not so high. Consequently, recognition for every other area may be skipped or recognition for a row may be skipped. If a fouled recognition mark cannot be recognized, a result of recognition of an adjacent recognition mark can be substituted.

Provided that bad marks 72 positioned on lateral rows of recognition marks 71 disposed in the X direction are recognized with recognition of the recognition marks 71, as shown in Fig. 4, and that the bad marks 72 are in midpoint positions between the recognition marks disposed at 10 mm intervals, for example, the recognition camera can be run at velocities that are changed according to presence or absence of the bad marks 72, that is, at a velocity such that the camera is run while the recognition marks 71 are recognized at 10 mm intervals, in areas where the bad marks 72 are absent, and at a velocity such that the recognition marks 71 or the bad marks 72 are recognized at 5 mm intervals, in vicinity of the bad marks 72.

In the method in which recognition marks are made into blocks for recognition as shown in Figs. 6 and 7, information on areas where bad marks 72 are provided may be recorded as a bar code or the like in a region other than the areas on the board 2 or may be provided separately as information concerning the board 2, in form of a data base or through such a storage medium as FD.

Appropriate combinations of arbitrary embodiments among the various embodiments described above are capable of achieving effects which the combined embodiments have.

In accordance with the present invention, operations of recognizing the recognition marks are executed while the placing head is run at a generally uniform velocity without being stopped one by one at every recognition mark for the recognition. Thus the recognition time can be reduced greatly, and mounting takt (cycle time) can be reduced.

Appropriate combinations of arbitrary embodiments among the various embodiments described above are capable of achieving effects which the combined embodiments have.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A component placement recognition mark recognizing device for recognizing recognition marks (71) for component placement that are provided corresponding to component placement positions (70) where components (80) are to be placed in a plurality of partition areas (2A) on a board (2), the component placement recognition mark recognizing device comprising:
a recognition camera (90) for recognizing the recognition marks straightly disposed in the plurality of areas, and
a moving device (5, 15) for running the recognition camera at a generally uniform velocity in a deposition direction in which the recognition marks are straightly disposed,
wherein the recognition marks are recognized with use of the recognition camera while the recognition camera is run by the moving device.

2. A component placement recognition mark recognizing device as claimed in claim 1, wherein the velocity at which the recognition camera is run by the moving device is a velocity obtained from a distance between adjoining recognition marks divided by time required for capture of an image of the recognition mark.

3. A component placement recognition mark recognizing device as claimed in claim 1 or 2, wherein the plurality of areas are made into one block (2A, 2B, 2C, 2D) and wherein the recognition marks (71A) for component placement that are located in a confronting pair of corners of the block and in different areas are recognized with use of the recognition camera.

4. A component placement recognition mark recognizing method for recognizing recognition marks (71) for component placement that are provided corresponding to component placement positions (70) where components (80) are to be placed in a plurality of partition areas (2A) on a board (2),
the component placement recognition mark recognizing method comprising: respectively recognizing the recognition marks straightly disposed in the plurality of areas with use of a recognition camera (90) while the recognition camera is run at a generally uniform velocity in a deposition direction in which the recognition marks are straightly disposed.

5. A component placement recognition mark recognizing method as claimed in claim 4, wherein the velocity at which the recognition camera is run by the moving device is a velocity obtained from a distance between adjoining recognition marks divided by time required for capture of an image of the recognition mark.

6. A component placement recognition mark recognizing method as claimed in claim 4 or 5, wherein the recognition marks (71A) for component placement that are located in a confronting pair of corners of one block (2A, 2B, 2C, 2D) composed of the plurality of areas and positioned in different areas are recognized with use of the recognition camera.
